# DEMANDE DE BREVET EUROPEEN

(11) **EP 1 104 095 A1**
(43) Date de publication de la demande: **30.05.2001**
(21) Numéro de dépôt: 00204007.9
(22) Date de dépôt: 14.11.2000
(51) Int. Cl.: H03G 1/00, G11B 20/10

(54) **Dispositif d'amplification à largeur de bande ajustable**

(30) Priorité: 23.11.1999 FR 9914745
(71) Demandeur: Koninklijke Philips Electronics N.V., 5621 BA Eindhoven (NL)
(72) Inventeur: Mulder, J., 75008 Paris (FR); Lugthart M., 75008 Paris (FR)
(74) Mandataire: Chaffraix, Jean

(57) **Abrégé**

La présente invention concerne un dispositif d'amplification de signaux électroniques, incluant :
. un amplificateur PRA, et
. une pluralité de boucles de rétroaction G1, G2, disposées entre la sortie et l'entrée de l'amplificateur, agencées de sorte que chacune d'elles présente un gain réglable, et de sorte qu'elles forment un ensemble présentant une impédance équivalente substantiellement indépendante des réglages de gain choisis.
Grâce à l'invention, la largeur de bande de l'amplification est aisément réglable, sans pour autant qu'un tel réglage ne provoque de dégradations des performances du dispositif en termes de bruit et de fréquence de coupure haute.

Application : Amplification de signaux provenant d'un tête de lecture de disque dur.

## Description

La présente invention concerne un dispositif d'amplification de signaux électroniques, incluant :
. un amplificateur muni d'une entrée et d'une sortie, et
. une boucle de rétroaction disposée entre la sortie et l'entrée de l'amplificateur.

De tels dispositifs sont couramment utilisés dans l'industrie électronique, pour amplifier, entre autres, des signaux audio, vidéo, ou encore des signaux de données provenant de têtes de lecture de disques durs. La théorie de ce type de dispositifs est décrite dans le chapitre 8 de l'ouvrage «Analysis and Design of Analog Integrated Circuits» de Mm. Gray et Meyer. Cet ouvrage décrit les avantages de la boucle de rétroaction, qui permet notamment de stabiliser le gain du dispositif d'amplification, de réaliser des adaptations des impédances d'entrée et de sortie du dispositif, de linéariser l'amplification qu'il opère, et d'augmenter la largeur de bande de l'amplification.
Pour certaines applications, il est souhaitable de permettre à l'utilisateur du dispositif d'amplification un réglage des paramètres définissant la largeur de bande de l'amplification, et en particulier de rendre ajustable la fréquence de coupure basse du dispositif d'amplification. Un tel réglage ne peut en principe s'opérer qu'en modifiant l'agencement de l'amplificateur lui-même, ou celui de la boucle de rétroaction. Ces deux options sont cependant néfastes au bon fonctionnement du dispositif. En effet, les éléments constituant l'amplificateur sont en principe dimensionnés pour produire le moins de bruit possible pendant son fonctionnement. Une modification des éléments qui le constituent aurait pour effet de rendre l'amplificateur plus bruyant, ce qui est à proscrire. Par ailleurs, les éléments constituant l'amplificateur et la boucle de rétroaction sont en principe dimensionnés de sorte que l'impédance d'entrée du dispositif d'amplification soit adaptée à l'impédance d'un élément, placé en amont du dispositif et destiné à délivrer à celui-ci le signal qu'il doit amplifier. Ceci est particulièrement vrai dans des applications d'amplification de signaux provenant d'une tête de lecture de disque dur via un flexible, applications où le taux de transfert de données, et donc la fréquence des signaux à amplifier, sont très élevées. Une modification des éléments constituant l'amplificateur lui-même ou la boucle de rétroaction aurait pour effet de perturber l'adaptation d'impédance, et donc de réduire la fréquence de coupure haute du dispositif d'amplification, ce qui est également à proscrire.

La présente invention a pour but de remédier à ces inconvénients en proposant un dispositif d'amplification dans lequel la largeur de bande de l'amplification est aisément réglable, sans pour autant qu'un tel réglage ne provoque de dégradations des performances du dispositif en termes de bruit et de fréquence de coupure haute.

En effet, selon l'invention, un dispositif d'amplification conforme au paragraphe introductif inclut une pluralité de boucles de rétroaction disposées entre la sortie et l'entrée de l'amplificateur, agencées de sorte que chacune d'elles présente un gain réglable, et de sorte qu'elles forment un ensemble présentant une impédance équivalente substantiellement indépendante des réglages de gain choisis.

Dans ce dispositif, il est possible de modifier l'agencement des boucles de rétroaction sans que l'impédance équivalente au dispositif d'amplification, vue depuis son entrée, ne varie. Il est donc possible de modifier la largeur de bande de l'amplification, plus particulièrement la fréquence de coupure basse de ladite bande, sans perturber l'adaptation d'impédance réalisée par l'ensemble des boucles de rétroaction. Par ailleurs, il n'est ainsi plus nécessaire de modifier les éléments constituant l'amplificateur lui-même, qui conserve alors les performances pour lesquelles il a été optimisé.

Dans une variante de l'invention, un dispositif d'amplification tel que décrit plus haut inclut une capacité de découplage disposée en amont de l'amplificateur, et au moins une première et une deuxième boucle de rétroaction respectivement disposées entre la sortie de l'amplificateur et des première et deuxième bornes de ladite capacité de découplage.

Dans cette variante de l'invention, la capacité de découplage a pour fonction de supprimer la composante continue du signal à amplifier, et permet une dissociation des première et deuxième boucles de rétroaction facilitant une modification de leurs agencements permettant de modifier la valeur de la fréquence de coupure basse du dispositif d'amplification, sans pour autant modifier l'impédance d'entrée équivalente du dispositif.

Dans un mode de réalisation avantageux de l'invention, chaque boucle de rétroaction est constituée d'au moins une première et d'une deuxième impédance commutable, une sélection de la première ou de la deuxième impédance étant opérée au moyen d'un premier et d'un deuxième interrupteur respectivement destinés à être pilotés par un premier et deuxième signal de contrôle.

Ce mode de réalisation permet un réglage simple et flexible de la fréquence de coupure basse du dispositif d'amplification par voie de programmation des signaux de contrôle. Le nombre de valeurs possibles pour la fréquence de coupure sera d'autant plus grand que le nombre de boucles de rétroaction et le nombre d'impédances commutables constituant lesdites boucles sera élevé.

Dans un mode de réalisation particulier de l'invention, l'impédance équivalente à une mise en parallèle des premières impédances des boucles de rétroaction est sensiblement égale à l'impédance équivalente à une mise en parallèle des deuxièmes impédances desdites boucles.

Dans un mode de réalisation préféré de l'invention, les impédances commutables sont des résistances.

Si la présente invention peut être utilisée dans tous types d'applications dans lesquelles une amplification d'un signal électronique est requise, sa mise en oeuvre est particulièrement avantageuse dans des applications d'amplification de signaux de données provenant de têtes de lecture de disques durs. L'invention concerne donc également un système de lecture incluant une tête de lecture, destinée à scruter un organe de stockage d'informations et à générer des signaux électroniques représentatifs desdites informations, et un dispositif d'amplification telle que décrit plus haut, destiné à amplifier lesdits signaux.

L'invention sera mieux comprise à l'aide de la description suivante, faite à titre d'exemple non-limitatif et en regard des dessins annexés, dans lesquels :
- la figure 1 est un schéma fonctionnel décrivant un dispositif d'amplification conforme à l'invention, et
- la figure 2 est un schéma fonctionnel décrivant un dispositif d'amplification conforme à un mode de réalisation préféré de l'invention.

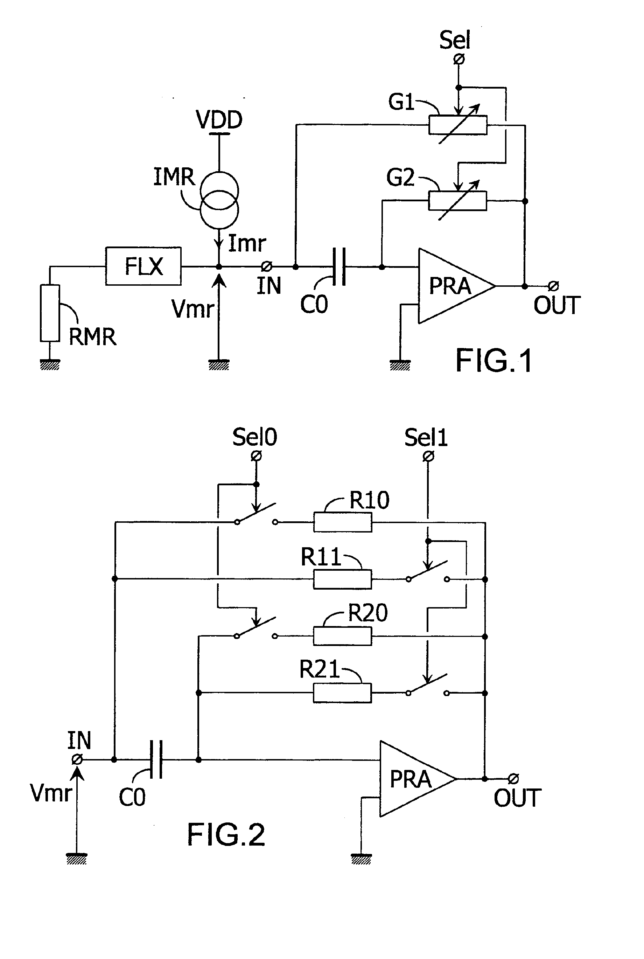

La figure 1 représente schématiquement un système de lecture incluant une tête de lecture, destinée à scruter un organe de stockage d'informations et à générer des signaux électroniques représentatifs desdites informations, et un dispositif d'amplification destiné à amplifier lesdits signaux. La tête de lecture comporte un barreau magnéto-résistif RMR, relié à une entrée IN du dispositif d'amplification via un flexible FLX. Le barreau magnéto-résistif RMR est polarisé au moyen d'une source de courant IMR qui débite un courant Imr. Le barreau magnéto-résistif RMR présente une résistance Rmr qui varie en fonction du champ magnétique auquel il est exposé. Ce barreau RMR génère donc un signal électronique Vmr, dont la valeur instantanée est égale à Rmr.Imr, si l'on néglige les pertes dues au flexible FLX, signal Vmr que le dispositif d'amplification doit amplifier.
Le dispositif d'amplification comporte dans cet exemple un amplificateur PRA et une première et une deuxième boucles de rétroaction G1 et G2. Dans d'autres modes de réalisation, il sera possible d'avoir un plus grand nombre de boucles de rétroaction qui réaliseront des contre-réactions positives et négatives. Les boucles de rétroaction G1 et G2 présentent des gains variables, dont les valeurs peuvent être ajustées par programmation de la valeur d'un signal de sélection Sel. Ce signal de sélection Sel peut être codé sur plusieurs bits, certains agissant sur la première boucle de rétroaction, d'autres agissant sur la deuxième boucle de rétroaction. Dans certaines applications, comme on le verra par la suite, on pourra prévoir que tous les bits du signal de sélection agissent simultanément sur toutes les boucles de rétroaction.
Les première et deuxième boucles de rétroaction G1 et G2 sont agencées de sorte qu'elles forment un ensemble présentant une impédance équivalente substantiellement indépendante des réglages de gain choisis.
Dans l'exemple de réalisation décrit ici, le dispositif d'amplification inclut une capacité de découplage C0 disposée en amont de l'amplificateur PRA, les première et deuxième boucle de rétroaction G1 et G2 étant respectivement disposées entre la sortie de l'amplificateur et des première et deuxième bornes de ladite capacité de découplage C0.
La capacité de découplage C0 a pour fonction de supprimer la composante continue du signal à amplifier Vmr, et permet une dissociation des première et deuxième boucles de rétroaction G1 et G2 facilitant une modification de leurs agencements permettant de modifier la valeur de la fréquence de coupure basse du dispositif d'amplification, sans pour autant modifier l'impédance d'entrée équivalente du dispositif, ce qui aurait perturbé l'adaptation d'impédance entre ledit dispositif et le flexible FLX.

La figure 2 est un schéma électrique qui représente un dispositif d'amplification conforme à un mode de réalisation préféré de l'invention. Dans ce dispositif, chaque boucle de rétroaction G1 et G2 est constituée d'une première et d'une deuxième impédance commutable (R10, R11) et (R20, R21), qui seront de préférence des résistances. Une sélection de la première ou de la deuxième impédance est opérée au moyen d'un premier et d'un deuxième interrupteur respectivement pilotés par un premier et deuxième signal de contrôle Sel0 et Sel1, qui sont deux bits du signal de sélection Sel décrit plus haut. Ce mode de réalisation permet à l'utilisateur du dispositif d'amplification de sélectionner une valeur de la fréquence de coupure basse dudit dispositif d'amplification parmi deux possibles. Un plus grand nombre de boucles de rétroaction et d'impédances commutables au sein de chacune desdites boucles donnera bien entendu accès à un plus grand nombre de valeurs possibles. Dans un même but, on aurait pu choisir d'utiliser un plus grand nombre de signaux de sélection afin d'obtenir un plus grand nombre de combinaisons possibles des différentes impédances commutables.
Les impédances commutables seront avantageusement choisies de sorte que l'impédance équivalente à une mise en parallèle des premières impédances (R10, R20) des boucles de rétroaction soit sensiblement égale à l'impédance équivalente à une mise en parallèle des deuxièmes impédances (R11, R21) desdites boucles, ce qui peut s'exprimer sous la forme suivante : (R10//R20)= (R11//R21).
Dans un autre mode de réalisation de l'invention, on pourra choisir de n'utiliser qu'une seule impédance pour réaliser l'une des boucles de rétroaction, par exemple une impédance R1 pour réaliser la première boucle de rétroaction G1, impédance R1 dont la valeur sera très inférieure à celles de toutes les autres impédances commutables. L'impédance équivalente de l'ensemble des boucles de rétroaction sera alors essentiellement égale à celle de la première boucle de rétroaction, et donc, dans une large mesure, indépendante des réglages opérés sur les autres boucles de rétroaction.

## Revendications

1. Dispositif d'amplification de signaux électroniques, incluant :
- un amplificateur muni d'une entrée et d'une sortie, et
- une pluralité de boucles de rétroaction disposées entre la sortie et l'entrée de l'amplificateur, agencées de sorte que chacune d'elles présente un gain réglable, et de sorte qu'elles forment un ensemble présentant une impédance équivalente substantiellement indépendante des réglages de gain choisis.

2. Dispositif d'amplification selon la revendication 1, incluant une capacité de découplage disposée en amont de l'amplificateur, et au moins une première et une deuxième boucle de rétroaction respectivement disposées entre la sortie de l'amplificateur et des première et deuxième bornes de ladite capacité de découplage.

3. Dispositif d'amplification selon la revendication 1, dans lequel chaque boucle de rétroaction est constituée d'au moins une première et d'une deuxième impédance commutable, une sélection de la première ou de la deuxième impédance étant opérée au moyen d'un premier et d'un deuxième interrupteur respectivement destinés à être pilotés par un premier et deuxième signal de contrôle.

4. Dispositif d'amplification selon la revendication 3, dans lequel l'impédance équivalente à une mise en parallèle des premières impédances des boucles de rétroaction est sensiblement égale à l'impédance équivalente à une mise en parallèle des deuxièmes impédances desdites boucles.

5. Dispositif d'amplification selon les revendications 3 ou 4, caractérisé en ce que les impédances commutables sont des résistances.

6. Système de lecture incluant une tête de lecture, destinée à scruter un organe de stockage d'informations et à générer des signaux électroniques représentatifs desdites informations, et un dispositif d'amplification conforme à la revendication 1, destiné à amplifier lesdits signaux.
